# EUROPEAN PATENT APPLICATION

(11) **EP 1 538 670 A2**
(43) Date of publication of application: **08.06.2005**
(21) Application number: 04028724.5
(22) Date of filing: 03.12.2004
(51) Int. Cl.: H01L 25/07

(54) **Semiconductor module**

(30) Priority: 05.12.2003 JP 2003408033
(71) Applicant: Kabushiki Kaisha Toyota Jidoshokki, Kariya-shi, Aichi-ken (JP)
(72) Inventor: Nodo, Takamasa, Kariya-shi Aichi-ken (JP)
(74) Representative: Leson, Thomas Johannes Alois, Dipl.-Ing.

(57) **Abstract**

A semiconductor module has a semiconductor device, a wiring substrate, an external terminal, and a conductor. The semiconductor device includes a main electrode through which a main electric current flows. The wiring substrate includes a base plate and a main wiring pattern provided on a surface of the base plate. The main electrode of the semiconductor device is in electrical contact with the main wiring pattern. The external terminal is provided for electrically connecting an external of the wiring substrate with the main wiring pattern. The conductor extends longitudinally along a main electric current path, through which the main electric current of the semiconductor device flows, from the external terminal, or a portion adjacent to the external terminal, to the main electrode or a portion adjacent to the main electrode, while being in electrical contact with the main wiring pattern.

## Description

### BACKGROUND OF THE INVENTION

The present invention relates to a semiconductor module including a semiconductor device such as power MOSFET and IGBT.

A semiconductor device (power device), such as power MOSFET and IGBT, for forming a semiconductor modules controls a relatively great magnitude of electric current. Since the great magnitude of electric current flows inside a circuit connected to such a semiconductor device, power loss and heating needs to be reduced in the circuit, so that resistance in the circuit (that is, wiring resistance) is preferably as small as possible.

Wiring resistance is reduced by employing a wiring pattern, which is made of a material having a low specific resistance, by making its cross-sectional area larger or by shortening the length of the circuit. The wiring pattern generally employs a copper material having a sufficiently low specific resistance. Therefore, it is difficult in an industrial process to reduce specific resistance of the wiring pattern more than in the prior art. Additionally, the length of a circuit of a wiring pattern is also substantially determined based upon the specification and structure of a semiconductor module, so that it cannot be shortened arbitrarily. However, the wiring resistance may be reduced by expanding the cross-sectional area of a wiring pattern.

As disclosed in Unexamined Japanese Patent Publication No. 5-129737, linear resist-printing is used to form a layer on a wiring substrate in parallel with the direction in which a large amount of electric current flows. Subsequently, solder is mounded on the wiring substrate so as to avoid the resist-printed layer. Thus, the cross-sectional area of a path through which a large amount of electric current flows is expanded thereby reducing wiring resistance.

As disclosed in Unexamined Japanese Patent Publication No. 7-86704, a metallic plate having a sufficient thickness is arranged on an insulation substrate to form a wiring pattern, and the cross-sectional area of the wiring pattern is expanded thereby reducing wiring resistance.

The mounded solder disclosed in the above Unexamined Japanese Patent Publication No. 5-129737 does not efficiently reduce wiring resistance because solder has a much greater specific resistance than a copper material which forms the wiring pattern. Additionally, the mounded solder requires resist-printed layer that needs a space thereof, so that the size of a wiring substrate, that is, the size of a semiconductor module, may not be reduced.

The formation of the wiring pattern, which is made of a metallic plate as disclosed in Unexamined Japanese Patent Publication No. 7-86704, leads to a lot of waste and cannot employ a cheap conventional wiring substrate, with a consequence of a high-cost semiconductor module.

Wiring resistance may be reduced by expanding the width of the wiring pattern so as to expand the cross-sectional area of the wiring pattern, but this undesirably leads to an enlarged semiconductor module. Therefore, there is a need for providing a semiconductor module that reduces its size and manufacturing cost, while it reduces wiring resistance of a circuit through which a large amount of electric current flows.

### SUMMARY OF THE INVENTION

In accordance with the present invention, a semiconductor module has a semiconductor device, a wiring substrate, an external terminal, and a conductor. The semiconductor device includes a main electrode through which a main electric current flows. The wiring substrate includes a base plate and a main wiring pattern provided on a surface of the base plate. The main electrode of the semiconductor device is in electrical contact with the main wiring pattern. The external terminal is provided for electrically connecting an external of the wiring substrate with the main wiring pattern. The conductor extends longitudinally along a main electric current path, through which the main electric current of the semiconductor device flows, from the external terminal, or a portion adjacent to the external terminal, to the main electrode or a portion adjacent to the main electrode, while being in electrical contact with the main wiring pattern.

Other aspects and advantages of the invention will become apparent from the following description, taken in conjunction with the accompanying drawings, illustrating by way of example the principles of the invention.

### BRIEF DESCRIPTION OF THE DRAWINGS

The features of the present invention that are believed to be novel are set forth with particularity in the appended claims. The invention together with objects and advantages thereof, may best be understood by reference to the following description of the presently preferred embodiments together with the accompanying drawings in which:
FIG. 1 is a perspective view of a semiconductor module according to a first preferred embodiment of the present invention;
FIG. 2 is a plan view of a semiconductor module according to a second preferred embodiment of the present invention; and
FIG. 3 is a plan view of a semiconductor module according to a third preferred embodiment of the present invention.

### DETAILED DESCRIPTION OF THE PREFERRED EMBODIMENTS

In preferred embodiments, for the sake of convenience, a prefix of "main" is used to name a particular electrode, wiring pattern, or electric current path of a semiconductor device, which indicates that a relatively large amount of electric current flows in the particular portion of the semiconductor device. For example, when the semiconductor device is an FET including a drain electrode, a source electrode and a gate electrode, a great magnitude of electric current (as compared with electric current flowing in the gate electrode) flows in the drain electrode and the source electrode is named as the main electric current. In this case, the source electrode and the drain electrode both are main electrodes. It is noted that the main electrode according to the present invention may be both the source and drain electrodes, or one of the electrodes. Supposing that the source electrode is determined as a main electrode, a wiring pattern from the source electrode to an external terminal is a main wiring pattern, and an electric current path from the source electrode to the external terminal is a main electric current path.

The phrase "a conductor longitudinally extends" in describing the preferred embodiments means that the conductor spindles to an extent that the wiring substrate is not expanded, and does not merely mean a simple linear or rectangular shape. It is sufficient that the main length of the conductor is longer than the width thereof.

An embodiment of the present invention will now be described.

### (1) Conductor

A conductor reduces wiring resistance of an electric current path, so that it is preferably made of a material having a low specific resistance (that is, a high conductivity). Thus, a conductor is preferably made of a metal such as a copper series material mainly containing copper (Cu) (including pure Cu) and an aluminum series material mainly containing aluminum (Al) (including pure Al). Particularly, the wiring pattern is generally made of a copper series material, so that the conductor is preferably made of the same copper series material.

The shape of the conductor is different according to a main electric current path. However, it is preferably bar-like or plate-like in view of productivity. When the arrangement of the main electrode and the external terminal causes the main electric current path to be curved, the shape of conductor may be formed along the above curve, or may be a polygonal line that is tangent to the above curve. The cross-section of the conductor may be rectangular, circular or semi-circular but it is preferably a shape that ensures a stable connection with the main wiring pattern. For example, the conductor includes a busbar, which is made of a bar-like metal.

It is noted that the conductor may be separated from the external terminal. However, the number of components is reduced when the conductor is integrated with the external terminal. Also, since the external terminal may be connected to a wiring substrate through the conductor, the external terminal does not need an exclusive fixing means.

The conductor and the main wiring pattern may mechanically be connected by a screw and the like, the conductor is preferably soldered onto the main wiring pattern in view of reliability and joint efficiency therebetween. When the conductor is integrated with the external terminal, a soldered connecting surface expands for the external terminal, so that the external terminal is firmly soldered onto the wiring substrate. It is noted that when a material of the conductor has a difficulty in direct soldering onto the main wiring pattern, the surface of the conductor may be plated and then soldered onto the main wiring pattern.

When a differential of the coefficient of thermal expansion between the conductor and the base plate of the wiring substrate is large, the wiring substrate may be warped with an increase in temperature. In this case, the conductor may be made of a material having a small differential of the coefficient of thermal expansion therebetween. When the base plate is made of Al series material, the conductor may also be made of Al series material. On the other hand, when the base plate is made of ceramics and the like having a low coefficient of expansion, the conductor is made of invar material and the like having a low coefficient of thermal expansion as a whole.

Furthermore, resist-printing may be treated on the surface of the conductor to form the wiring pattern. Also, the main electrode may be welded directly to the conductor by soldering and the like.

The conductor may be made of a flexible plate-like lead or a wire and the like formed by wire bonding. In these cases, one end is welded to the main electrode or the main wiring pattern adjacent to the main electrode, and the other end is in electrical contact with the external terminal or the main wiring pattern adjacent to the external terminal.

### (2) Semiconductor Device

A semiconductor module according to the present invention does not specify a kind of semiconductor device mounted thereon, but it is appropriate for a high power device. Such a semiconductor device includes a power transistor such as an IGBT, a power MOSFET, a diode and the like. When the semiconductor device is a transistor, the main electrode is a collector electrode or an emitter electrode. When the semiconductor device is a field-effect transistor (FET), the main electrode is a drain electrode or a source electrode. When the semiconductor device is a diode, the main electrode is an anode electrode or a cathode electrode. It is noted that control current flowing through the base electrode, the gate electrode and the like is generally much smaller than the main electric current, so that the conductor mentioned in the present invention need not be exclusively provided.

The number of the semiconductor devices mounted on one wiring substrate may be singular or plural and may be a singular type or plural types. The wiring pattern and the shape of the conductor are determined in accordance with the number of semiconductor devices and the type thereof. If a single semiconductor device mounted on one wiring substrate is smaller than the wiring substrate, the expansion of the main wiring pattern makes it possible to reduce wiring resistance of the main electric current. The conductor is provided to reduce wiring resistance according to the present invention, which is effective when the wiring substrate is small or when a plurality of semiconductor devices is mounted on one wiring substrate in high density (that is, when a plurality of semiconductor devices is mounted in parallel on one wiring substrate). Particularly, when a plurality of semiconductor devices is mounted in parallel, main electric current flowing in the main wiring pattern increases with the number of the semiconductor devices.

### (3) Wiring Substrate

The wiring substrate mainly includes a base plate and a wiring pattern provided on the surface of the base plate. The base plate may be made of metal, ceramics, and the like. When the base plate is made of metal, an insulation layer, such as resin, is generally interposed between the base plate and the wiring pattern. A commercially available low-cost copper-clad wiring substrate may be used for any of the above components. It is noted that the base plate may be made of invar alloys or may be made of composite materials of ceramics fibers and metals.

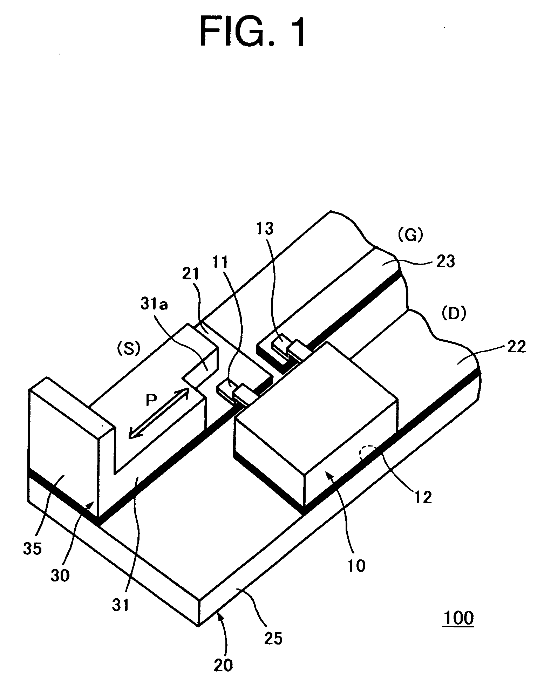

A first preferred embodiment of a semiconductor module 100 according to the present invention will now be described with reference to FIG. 1. FIG. 1 illustrates a perspective view of the semiconductor module 100. This semiconductor module 100 is used for a step-down type DC-DC converter, and FIG. 1 shows a part of the converter.

The semiconductor module 100 includes a MOSFET 10 (or a semiconductor device), which is a high power device, a single-sided copper-clad metallic base wiring substrate 20 mounting thereon the MOSFET 10, and a conductive member 30 (or a conductor).

The MOSFET 10 includes a source electrode 11 (or a main electrode), a drain electrode 12, and a gate electrode 13. The source electrode 11 and the gate electrode 13 are non-planar in shape, and the drain electrode 12 is planar in shape and provided on the backside of the MOSFET 10.

The wiring substrate 20 has a thin copper foil which adheres on the upper surface (the upper side of the drawing) of a metallic base plate 25. The copper foil is made in a desired shape, so that a source wiring pattern 21 (or a main wiring pattern), a drain wiring pattern 22, and a gate wiring pattern 23 are formed.

The conductive member 30 is a substantially L-shaped member made of copper, and is made by integrating a busbar 31 and an external terminal 35. The conductive member 30 is provided for electrically connecting the source wiring pattern 21 to an external of the wiring substrate 20. The busbar 31 is sufficiently thicker (higher) than the source wiring pattern 21, and its bottom is entirely soldered onto the source wiring pattern 21.

It is noted that the distal end of the busbar 31 is formed to have a recess 31 a for avoiding the source electrode 11. The source electrode 11 is soldered onto the source wiring pattern 21 at this recess 31 a. Also, the drain electrode 12 of the MOSFET 10 is soldered onto the drain wiring pattern 22, and the gate electrode 13 of the MOSFET 10 is soldered onto the gate wiring pattern 23.

Thus, the busbar 31, which extends longitudinally along a main electric current path P, is provided in the semiconductor module 100, so that wiring resistance between a portion adjacent to the source electrode 11 and the external terminal 35 reduces, with a consequence of prevented loss and heating therebetween. Furthermore, the busbar 31 expands surface area at the portion thereof in comparison to the structure only having the source wiring pattern 21, so that heating of the MOSFET 10 is efficiently radiated at the portion.

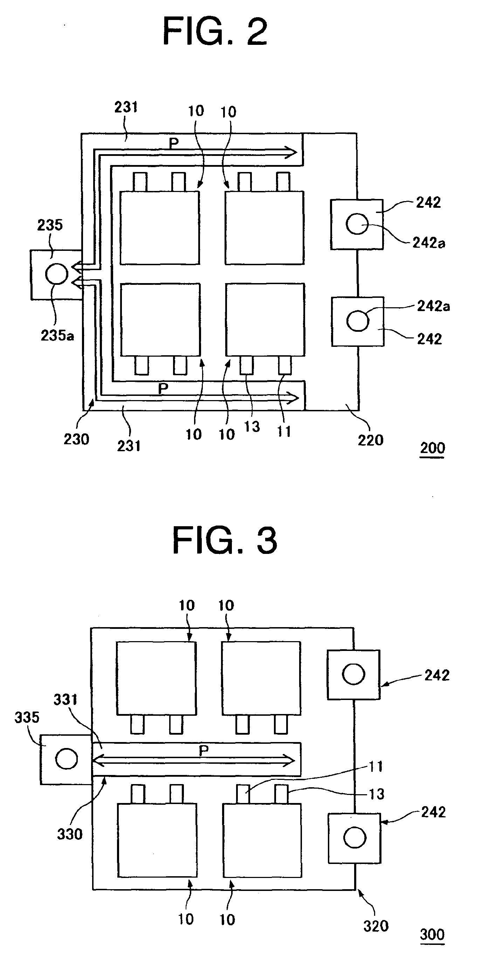

A second preferred embodiment of a semiconductor module 200 according to the present invention will now be described with reference to FIG. 2. FIG. 2 illustrates a plan view of the semiconductor module 200. The same reference numerals as in the first preferred embodiment denote the substantially identical components to those of the first preferred embodiment.

In the second preferred embodiment, four MOSFETs 10 are mounted on a common wiring substrate 220 such that each source electrode 11 and gate electrode 13 face outward. A substantially U-shaped conductive member 230 is arranged around the MOSFETs 10, while two external terminals 242 are arranged on the side of the drain wiring pattern.

The conductive member 230 is a pressing member made of copper plate and includes a U-shaped bus 231 and an external terminal 235 arranged on the middle of the conductive member 230. In the second preferred embodiment, the U-shaped bus 231 extends between each source electrode 11 and the external terminal 235 along the main electric current path P, so that wiring resistance therebetween is reduced.

It is noted that threaded screws for fastening the external terminals to the outside are threaded through connecting hole 235a formed in the external terminal 235 and connecting holes 242a formed in the external terminals 242. In the second preferred embodiment, the detail of the wiring pattern on the wiring substrate 220 is omitted for easier understanding, but it remains that the conductive member 230 is entirely soldered onto the source wiring pattern.

A third preferred embodiment of a semiconductor module 300 according to the present invention will now be described with reference to FIG. 3. FIG. 3 illustrates a schematic plan view of the semiconductor module 300. The same reference numerals as in the first and second preferred embodiments denote the substantially identical components to those of the first and second preferred embodiments.

In the third preferred embodiment, four MOSFETs 10 are mounted on a common wiring substrate 320, such that each source electrode 11 and gate electrode 13 face inward. A conductive member 330 is arranged in between MOSFETs 10, while two external terminals 242 are arranged on the side of the drain wiring pattern.

The conductive member 330 is a pressing member made of copper plate, and includes a bus 331 arranged adjacent to each source electrode 11 and an external terminal 335 arranged at the end of the bus 331. In the third preferred embodiment, the linear bus 331 extends longitudinally between each source electrode 11 and the external terminal 335 along the main electric current path P, so that wiring resistance therebetween is reduced. Additionally, the detail of the wiring pattern on the wiring substrate 320 is omitted for easier understanding, but it remains that the conductive member 330 is entirely soldered onto the source wiring pattern.

The above preferred embodiments disclose that the semiconductor device is MOSFET. In an alternative embodiment, the semiconductor device may be IGBT, diode and the like.

Therefore, the present examples and embodiments are to be considered as illustrative and not restrictive, and the invention is not to be limited to the details given herein but may be modified within the scope of the appended claims.

A semiconductor module has a semiconductor device, a wiring substrate, an external terminal, and a conductor. The semiconductor device includes a main electrode through which a main electric current flows. The wiring substrate includes a base plate and a main wiring pattern provided on a surface of the base plate. The main electrode of the semiconductor device is in electrical contact with the main wiring pattern. The external terminal is provided for electrically connecting an external of the wiring substrate with the main wiring pattern. The conductor extends longitudinally along a main electric current path, through which the main electric current of the semiconductor device flows, from the external terminal, or a portion adjacent to the external terminal, to the main electrode or a portion adjacent to the main electrode, while being in electrical contact with the main wiring pattern.

## Claims

1. A semiconductor module comprising a semiconductor device, a wiring substrate, an external terminal, and a conductor, wherein the semiconductor device includes a main electrode through which a main electric current flows, **characterized in that** the wiring substrate includes a base plate and a main wiring pattern provided on a surface of the base plate, **in that** the main electrode of the semiconductor device is in electrical contact with the main wiring pattern, **in that** the external terminal is provided for electrically connecting an external of the wiring substrate with the main wiring pattern, and **in that** the conductor extends longitudinally along a main electric current path, through which the main electric current of the semiconductor device flows, from the external terminal or a portion adjacent to the external terminal to the main electrode or a portion adjacent to the main electrode, while being in electrical contact with the main wiring pattern.

2. The semiconductor module according to claim 1, wherein the conductor is integrated with the external terminal.

3. The semiconductor module according to any one of claims 1 and 2, wherein the conductor is a bar-like metallic busbar.

4. The semiconductor module according to any one of claims 1 through 3, wherein the conductor is soldered onto the main wiring pattern.

5. The semiconductor module according to any one of claims 1 through 4, wherein the main electrode is a collector electrode or an emitter electrode when the semiconductor device is a transistor; the main electrode being a drain electrode or a source electrode, when the semiconductor device is a field-effect transistor; the main electrode being an anode or a cathode when the semiconductor device is a diode.

6. The semiconductor module according to any one of claims 1 through 5, wherein a plurality of the semiconductor devices are mounted in parallel on the wiring substrate.

7. The semiconductor module according to claim 6, wherein the conductor is arranged to extend between each main electrode and the external terminal along the main electric current path.

8. The semiconductor module according to claim 7, wherein each main electrode faces outward, the substantially U-shaped conductor being arranged around the outward facing main electrodes of the semiconductor devices.

9. The semiconductor module according to claim 7, wherein each main electrode faces inward, the conductor being arranged in between the inward facing main electrodes of the semiconductor devices.
